# EUROPEAN PATENT APPLICATION

(11) **EP 4 779 826 A1**
(43) Date of publication of application: **22.07.2026**
(21) Application number: 26152222.1
(22) Date of filing: 16.01.2026
(51) Int. Cl.: H02H 3/05, H02H 3/08, H02H 3/24, H02H 5/04

(54) **SOLID-STATE CIRCUIT BREAKER**

(30) Priority: 17.01.2025 CN 202520107227 U
(71) Applicant: SCHNEIDER ELECTRIC INDUSTRIES SAS, 92500 Rueil-Malmaison (FR)
(72) Inventor: ZHU, Qilei, SHANGHAI, 201203 (CN); HUANG, Jie, SHANGHAI, 201203 (CN); BAI, Wanlong, SHANGHAI, 201203 (CN); SHI, Ying, SHANGHAI, 201203 (CN)
(74) Representative: Lavoix

(57) **Abstract**

Embodiments of the present disclosure provide a solid-state circuit breaker. The solid-state circuit breaker includes a switching unit, a driving circuit, a control unit and a protection circuit. The driving circuit is electrically connected to the switching unit and is adapted to be switched between a first state and a second state. In a case that the driving circuit is in the first state, the driving circuit is adapted to control the switching unit to be turned on or off, and in a case that the driving circuit is in the second state, the driving circuit stops control of the switching unit. The control unit is adapted to continuously send a first signal after being powered on. The protection circuit controls the driving circuit to be in the first state in response to receiving the first signal and in the second state in response to not receiving the first signal.

## Description

### FIELD

Embodiments of the present disclosure generally relate to the field of electrical equipment, and in particular, to a solid-state circuit breaker.

### BACKGROUND

In the power distribution industry, products are continuously developing towards digitization and intelligence, and the safety is also increasingly important. For example, power distribution products such as solid-state circuit breakers are widely used in the market. In some conventional solid-state circuit breakers, a solid-state switching unit is controlled to be turned on or off by a control unit, and when a program malfunction or a system failure is encountered, the circuit breaker may not accurately control the state of the solid-state switching unit, thereby increasing the risk of the circuit system.

### SUMMARY

An object of embodiments of the present disclosure is to provide a solid-state circuit breaker to at least partially solve the above problems and other potential problems.

The present disclosure provides a solid-state circuit breaker. The solid-state circuit breaker includes: a switching unit; a driving circuit electrically connected to the switching unit and adapted to be switched between a first state and a second state, where in a case that the driving circuit is in the first state, the driving circuit is adapted to control the switching unit to be turned on or off, and in a case that the driving circuit is in the second state, the driving circuit stops control of the switching unit; a control unit adapted to continuously send a first signal after being powered on; and a protection circuit electrically connected to the control unit and the driving circuit, where the protection circuit controls the driving circuit to be in the first state in response to receiving the first signal, and controls the driving circuit to be in the second state in response to not receiving the first signal.

In some embodiments, the protection circuit includes: a level conversion circuit electrically connected to the control unit and the driving circuit to convert the first signal into a high level signal; and a logic conversion circuit electrically connected to the level conversion circuit and the driving circuit, where the logic conversion circuit controls the driving circuit to be in the first state in response to receiving the high level signal, and controls the driving circuit to be in the second state at least in response to not receiving the high level signal.

In some embodiments, the level conversion circuit includes: a diode; a first capacitor electrically connected between the control unit and an anode of the diode; a second capacitor having an end electrically connected to an cathode of the diode and the other end electrically connected to a ground terminal of the control unit; a first resistor having an end electrically connected to the cathode of the diode and the other end electrically connected to the ground terminal of the control unit; and a second resistor having an end electrically connected to the ground terminal of the control unit and the other end electrically connected to a node between the first capacitor and the anode of the diode.

In some embodiments, the control unit is electrically connected to the driving circuit to send a control signal to the driving circuit, and the driving circuit controls the switching unit to be turned on in response to receiving the control signal.

In some embodiments, the first signal includes at least one of a pulse width modulated signal and a fixed frequency pulse signal.

In some embodiments, the solid-state circuit breaker further includes an undervoltage protection circuit electrically connected to the logic conversion circuit, and the undervoltage protection circuit is adapted to generate a second signal in a case that an undervoltage occurs in a circuit, so that the logic conversion circuit controls the driving circuit to be in the second state at least in response to receiving the second signal.

In some embodiments, the solid-state circuit breaker further includes: a short-circuit protection circuit electrically connected to the logic conversion circuit, and the short-circuit protection circuit is adapted to generate a third signal in a case that a short-circuit condition occurs in a main loop, so that the logic conversion circuit controls the driving circuit to be in the second state at least in response to receiving the third signal.

In some embodiments, the solid-state circuit breaker further includes: an over-temperature protection circuit electrically connected to the logic conversion circuit, and the over-temperature protection circuit is adapted to generate a fourth signal in a case that an over-temperature condition occurs in a main loop, so that the logic conversion circuit controls the driving circuit to be in the second state at least in response to receiving the fourth signal.

In some embodiments, the driving circuit includes an application-specific integrated circuit or a circuit formed by connecting a plurality of discrete components.

In some embodiments, the switching unit includes at least one of a metal oxide semiconductor field effect transistor or an insulated gate bipolar transistor.

In embodiments of the present disclosure, a solid-state circuit breaker includes a switching unit, a driving circuit, a control unit, and a protection circuit. The driving circuit is electrically connected to the switching unit and is adapted to be switched between a first state and a second state. In a case that the driving circuit is in the first state, the driving circuit is adapted to control the switching unit to be turned on or off, and in a case that the driving circuit is in the second state, the driving circuit stops control of the switching unit. The control unit is adapted to continuously send a first signal after being powered on. The protection circuit is electrically connected to the control unit and the driving circuit, the protection circuit controls the driving circuit to be in the first state in response to receiving the first signal, and controls the driving circuit to be in the second state in response to not receiving the first signal. With this arrangement, the driving circuit can control the switching unit to be turned on or off when the program and system are operating normally. The driving circuit stops control of the switching unit when the program malfunction or system failure occurs. At this time, the driving circuit cannot send the control signal to the switching unit, and the switching unit is switched to an off state, thereby increasing the safety of the circuit system.

It should be understood that the content described in this content section is not intended to limit the key features or important features of embodiments of the present disclosure, nor is it intended to limit the scope of the present disclosure. Other features of the present disclosure will become readily understood from the following description.

### BRIEF DESCRIPTION OF DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements, wherein:
FIG. 1 illustrates a circuit block diagram of a solid-state circuit breaker according to some embodiments of the present disclosure;
FIG. 2 illustrates a schematic circuit diagram of a solid-state circuit breaker according to some embodiments of the present disclosure;
FIG. 3 illustrates a schematic diagram of a level conversion circuit according to some embodiments of the present disclosure;
FIG. 4 illustrates a timing diagram of a first signal according to some embodiments of the present disclosure;
FIG. 5 illustrates a timing diagram of a level conversion circuit converting a first signal to a high level signal according to some embodiments of the present disclosure; and
FIG. 6 illustrates a timing diagram of a control signal according to some embodiments of the present disclosure.

### Reference numbers indicate:

10: switching unit;
20: driving circuit;
30: control unit;
40: protection circuit; 41: level conversion circuit; 411: diode; 412: first capacitor; 413: second capacitor; 414: first resistor; 415: second resistor; 42: logic conversion circuit;
50: undervoltage protection circuit;
60: short-circuit protection circuit;
70: over-temperature protection circuit.

### DETAILED DESCRIPTION

Embodiments of the present disclosure will be described in more detail below with reference to the accompanying drawings. While the embodiments of the present disclosure are shown in the drawings, it should be understood that the present disclosure may be implemented in various forms and should not be limited by embodiments set forth herein. Rather, these embodiments are provided to make this disclosure more thorough and complete, and to fully convey the scope of the present disclosure to those skilled in the art.

As used herein, the term "including" and variations thereof represent openness, i.e., "including but not limited to". Unless specifically stated, the term "or" means "and/or". The term "based on" means "based at least in part on". The terms "an example embodiment" and "an embodiment" mean "at least one example embodiment". The term "another embodiment" means "at least one further embodiment". The terms "first," "second," and the like may refer to different or identical objects.

As described above, in some conventional solid-state circuit breakers, a solid-state switching unit is controlled to be turned on or off by a control unit, and when a program malfunction or a system failure is encountered, the circuit breaker may not accurately control the state of the solid-state switching unit, thereby increasing the risk of the circuit system.

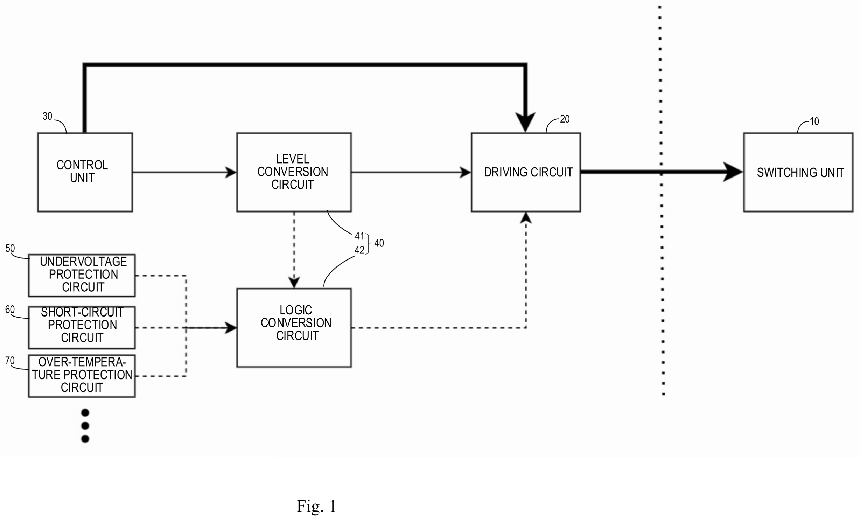

Embodiments of the present disclosure provide a solid-state circuit breaker. The solid-state circuit breaker includes a switching unit, a driving circuit, a control unit and a protection circuit. The driving circuit is electrically connected to the switching unit and is adapted to be switched between a first state and a second state. In a case that the driving circuit is in the first state, the driving circuit is adapted to control the switching unit to be turned on or off, and in a case that the driving circuit is in the second state, the driving circuit stops control of the switching unit. The control unit is adapted to continuously send a first signal after being powered on. The protection circuit is electrically connected to the control unit and the driving circuit, the protection circuit controls the driving circuit to be in the first state in response to receiving the first signal, and controls the driving circuit to be in the second state in response to not receiving the first signal. With this arrangement, the driving circuit can control the switching unit to be turned on or off when the program and system are operating normally. The driving circuit stops control of the switching unit when the program malfunction or system failure occurs. At this time, the driving circuit cannot send the control signal to the switching unit, and the switching unit is switched to an off state, thereby increasing the safety of the circuit system. The principles of the present disclosure will be described in detail below with reference to FIGS. 1 to 6.

As shown in FIG. 1 to FIG. 3, a solid-state circuit breaker can respond to abnormal conditions such as overload or short-circuit condition in a circuit, and protect the safety of electrical equipment and lines by cutting off a main loop. In embodiments of the present disclosure, the solid-state circuit breaker includes a switching unit 10, a driving circuit 20, a control unit 30, and a protection circuit 40.

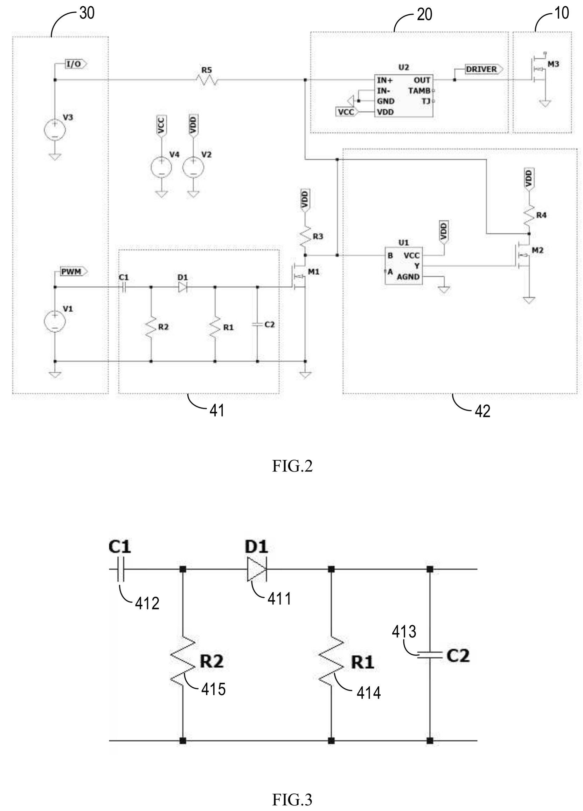

As shown in FIG. 1 and FIG. 2, the switching unit 10 may be electrically connected to the main loop on a high voltage side to control the main loop to be turned on and off. The driving circuit 20 is electrically connected to the switching unit 10, and may control the switching unit 10 to determine whether to allow a current to pass through the main loop in different states. When the driving circuit 20 is in the first state, the driving circuit 20 may control the switching unit 10 to be turned on or off. When the driving circuit 20 is switched to the second state, the driving circuit 20 stops control of the switching unit 10. For example, the second state of the driving circuit 20 is a grounded low level state. In this state, even if an external control signal attempts to change the state of the switching unit 10, the driving circuit 20 does not perform a corresponding action.

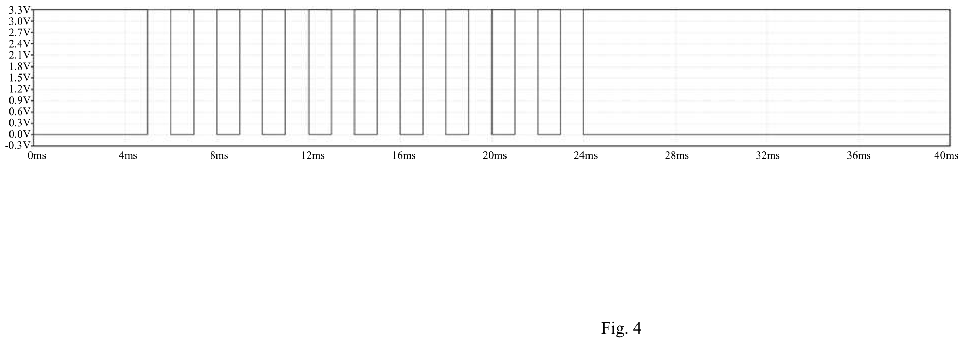

As shown in FIG. 4, the control unit 30 can continuously send a first signal after being powered on. The first signal is used to indicate that the control unit 30 is in a good operation condition, and provide a reference for other components.

As an example, the first signal may include a pulse width modulated (PWM) signal. In the solid-state circuit breaker, the pulse width modulated signal generated by the control unit 30 may be used to control the behavior of the driving circuit 20. At a fixed frequency, different instructions may be communicated by adjusting a proportion of the high level duration (i.e., duty cycle).

As another example, the first signal may include a fixed frequency pulse signal. The fixed frequency pulse signal occurs repeatedly within a specific time interval, and its frequency remains constant.

It should be understood that, in other embodiments, the first signal may also be other types of digital signals, which is not intended to be limited in the present disclosure.

As shown in FIG. 1 and FIG. 2, the protection circuit 40 is electrically connected to the control unit 30 and the driving circuit 20. The protection circuit 40 may control the driving circuit 20 to remain in the first state in response to receiving the first signal sent by the control unit 30, thereby allowing the driving circuit 20 to perform a normal control operation on the switching unit 10. In a case of a program malfunction or a system failure, the control unit 30 cannot continuously send the first signal. At this time, the protection circuit 40 controls the driving circuit 20 to enter the second state.

In this way, during normal operation of the program and the system, since the control unit 30 continuously sends the first signal, the protection circuit 40 remains the driving circuit 20 in the first state, and the driving circuit 20 can normally control the switching unit 10 to be turned on or off. In a case that the program malfunction or the system failure is encountered, the first signal sent by the controller is interrupted, and the protection circuit 40 controls the driving circuit 20 to be in the second state. At this time, even if the control unit 30 sends a control signal to the driving circuit 20, the driving circuit 20 cannot control the switching unit 10 to be turned on. At this time, the switching unit 10 automatically is switched to the off state, which can avoid the main loop to be turned on during the program malfunction or system failure, thereby improving the safety of the circuit system.

In some embodiments, as shown in FIG. 1 and FIG. 2, the protection circuit 40 includes a level conversion circuit 41 and a logic conversion circuit 42. The level conversion circuit 41 is electrically connected to the control unit 30 and the driving circuit 20.

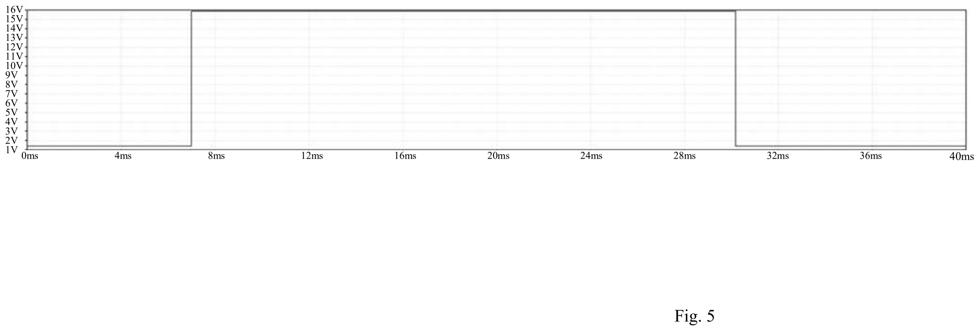

As shown in FIG. 4 and FIG. 5, the level conversion circuit 41 may convert the first signal from the control unit 30 into a high level signal adapted for subsequent processing, making it meet the standard sufficient to trigger the logic conversion circuit 42 to operate.

The logic conversion circuit 42 is electrically connected to the level conversion circuit 41 and the driving circuit 20. After receiving the high level signal, the logic conversion circuit 42 may perform a corresponding operation to determine the state of the driving circuit 20. The logic conversion circuit 42 controls the driving circuit 20 to remain in the first state upon detecting the presence of the high level signal. In this state, the driving circuit 20 may normally control the switching unit 10, to turn on or off the main loop as needed. If the logic conversion circuit 42 fails to receive the high level signal, it means that the program or system has an abnormal condition, such as a program malfunction or a hardware failure. At this time, the logic conversion circuit 42 controls the driving circuit 20 to enter the second state. In the second state, the driving circuit 20 stops control of the switching unit 10 and prevents unsafe operation caused by the external command turning on the switching unit 10.

In some embodiments, as shown in FIG. 3, the level conversion circuit 41 includes a diode 411, a first capacitor 412, a second capacitor 413, a first resistor 414, and a second resistor 415. The first capacitor 412 is electrically connected between the control unit 30 and an anode of the diode 411. The first capacitor 412 is configured to filter and smooth an input signal from the control unit 30, eliminating the possible high-frequency noise to ensure the purity of the signal. When the control unit 30 sends out the first signal, the first capacitor 412 makes the signal more stable.

An end of the second capacitor 413 is connected to a cathode of the diode 411, and the other end is grounded to a ground terminal of the control unit 30. The second capacitor 413 may filter an output signal after passing through the diode 411 to ensure its stability. In addition, the second capacitor 413 may guide high-frequency interference to the ground, thereby avoiding affecting normal operation of the system.

An end of the first resistor 414 is electrically connected to the cathode of the diode 411, and the other end is electrically connected to the ground terminal of the control unit 30. The first resistor 414 may serve to limit current and divide voltage, which may limit the magnitude of the current flowing through the diode 411, thereby preventing excessive current from damaging the diode 411 or other components.

An end of the second resistor 415 is grounded, and the other end is connected to a node between the first capacitor 412 and the anode of the diode 411. The second resistor 415 may provide a loop path allowing the first capacitor 412 to charge or discharge and maintain the voltage level of the node when there is no signal input.

In the level conversion circuit 41, the diode 411 is used for rectifying, the two capacitors are respectively responsible for filtering the input signal and the output signal, and the two resistors are used for current limiting, voltage division and adjustment of the static operation point. In this way, the level conversion circuit 41 can improve the reliability and anti-interference performance of the solid-state circuit breaker.

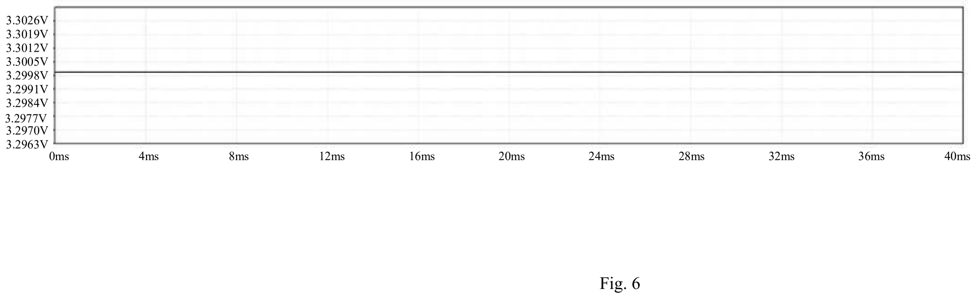

In some embodiments, as shown in FIG. 1 and FIG. 2, the control unit 30 is electrically connected to the driving circuit 20. As shown in FIG. 6, when the solid-state circuit breaker is in a normal operation mode, the control unit 30 may generate and send the control signal to the driving circuit 20. The driving circuit 20 may control the switching unit 10 to turn on the main loop in response to receiving the control signal.

In some embodiments, as shown in FIG. 1, the solid-state circuit breaker further includes an undervoltage protection circuit 50. The undervoltage protection circuit 50 is electrically connected to the logic conversion circuit 42. In a case that an undervoltage occurs in the main loop, for example, a voltage drop caused by grid fluctuation, power failure or other external factors, the undervoltage protection circuit 50 will activate a protection mechanism. In some embodiments, the undervoltage protection circuit 50 includes a voltage comparator that can monitor the input voltage and compare it with a preset safety threshold. Upon detecting that an actual voltage is below the safety threshold, the undervoltage protection circuit 50 generates a second signal.

The logic conversion circuit 42 switches the driving circuit 20 to the second state in response to receiving the second signal. In the second state, the driving circuit 20 stops control of the switching unit 10 and no longer allows the current to pass through, thereby cutting off the main loop.

In some embodiments, as shown in FIG. 1, the solid-state circuit breaker further includes a short-circuit protection circuit 60. The short-circuit protection circuit 60 is electrically connected to the logic conversion circuit 42. In a case that a short-circuit condition occurs in the main loop, the current in the main loop increases dramatically beyond the normal operating range. The short-circuit protection circuit 60 identifies an abnormal current change phenomenon, and when it is determined that the short-circuit condition exists, the short-circuit protection circuit 60 generates a third signal.

The logic conversion circuit 42 switches the driving circuit 20 to the second state in response to receiving the third signal. In the second state, the driving circuit 20 stops sending a control instruction to the switching unit 10, and the switching unit 10 automatically enters a high impedance or the off state, thereby quickly cutting off the current flow in the main loop.

In some embodiments, as shown in FIG. 1, the solid-state circuit breaker further includes an over-temperature protection circuit 70. The over-temperature protection circuit 70 is electrically connected to the logic conversion circuit 42. When the temperature of the main loop rises beyond the safe range due to overload, an increased ambient temperature, or other factors, a temperature sensor built in the over-temperature protection circuit 70 detects a temperature change and generates a fourth signal when the temperature exceeds the limit.

After receiving the fourth signal, the logic conversion circuit 42 switches the driving circuit 20 to the second state. In the second state, the driving circuit 20 stops sending the control instruction to the switching unit 10, causing the switching unit 10 to automatically enter the high impedance or the off state, thereby cutting off the current flow in the main loop.

It should be understood that the logic conversion circuit 42 may be a multi-channel OR gate, and the state of the driving circuit 20 may be controlled under different signals.

In some embodiments, the driving circuit 20 includes an application-specific integrated circuit. In the solid-state circuit breaker, the application-specific integrated circuit may efficiently process signals from the control unit 30 and control the operation of the switching unit 10. The application-specific integrated circuit not only can simplify the circuit structure, but also can reduce the number of external components, thereby improving the reliability and the response speed of the system.

In other embodiments, the driving circuit 20 may include a circuit formed by connecting a plurality of discrete components. The discrete components may include, for example, transistors, resistors, capacitors, diodes, and the like, which are connected together by a topological structure, or may form a fully functional driving system.

In some embodiments, the switching unit 10 may be a metal oxide semiconductor field effect transistor (MOSFET). In this configuration, the control unit 30 may instruct the driving circuit 20 to operate by generating a specific control signal. The control signal is transmitted to the gate of the MOSFET to control the on or off state between its source and drain. When the MOSFET receives a sufficient gate voltage, it enters the on state and allows current to flow from the source to the drain, thereby enabling the main loop to be turned on. In a case that the gate voltage is insufficient to maintain a conductive channel, the MOSFET is switched to the high impedance state, and the main loop can be cut off.

In other embodiments, the switching unit 10 may be an insulated gate bipolar transistor (IGBT). The driving circuit 20 may adjust the voltage applied to the gate of the insulated gate bipolar transistor according to the received instruction, and may determine whether the gate of the insulated gate bipolar transistor is turned on or off, so as to control the on-off state of the main loop.

It should be understood that, in other embodiments, the switching unit 10 may also include a delay switch or a contactor, which is not intended to be limited in the present disclosure.

Various embodiments of the present disclosure have been described above, which are illustrative, not exhaustive, and are not limited to the embodiments disclosed. Many modifications and variations will be apparent to those of ordinary skill in the art without departing from the scope and the illustrated embodiments. The selection of the terms used herein is intended to best explain the principles of the embodiments, practical applications, or technical improvements in the marketplace, or to enable others of ordinary skill in the art to understand the embodiments disclosed herein.

## Claims

1. A solid-state circuit breaker, **characterized by** comprising:
a switching unit (10);
a driving circuit (20) electrically connected to the switching unit (10) and adapted to be switched between a first state and a second state, wherein in a case that the driving circuit (20) is in the first state, the driving circuit (20) is adapted to control the switching unit (10) to be turned on or off, and in a case that the driving circuit (20) is in the second state, the driving circuit (20) stops control of the switching unit (10);
a control unit (30) adapted to continuously send a first signal after being powered on; and
a protection circuit (40) electrically connected to the control unit (30) and the driving circuit (20), wherein the protection circuit (40) controls the driving circuit (20) to be in the first state in response to receiving the first signal, and controls the driving circuit (20) to be in the second state in response to not receiving the first signal.

2. The solid-state circuit breaker of claim 1, **characterized in that** the protection circuit (40) comprises:
a level conversion circuit (41) electrically connected to the control unit (30) and the driving circuit (20) to convert the first signal into a high level signal; and
a logic conversion circuit (42) electrically connected to the level conversion circuit (41) and the driving circuit (20), wherein the logic conversion circuit (42) controls the driving circuit (20) to be in the first state in response to receiving the high level signal, and controls the driving circuit (20) to be in the second state at least in response to not receiving the high level signal.

3. The solid-state circuit breaker of claim 2, **characterized in that** the level conversion circuit (41) comprises:
a diode (411);
a first capacitor (412) electrically connected between the control unit (30) and an anode of the diode (411);
a second capacitor (413) having an end electrically connected to an cathode of the diode (411) and the other end electrically connected to a ground terminal of the control unit (30);
a first resistor (414) having an end electrically connected to the cathode of the diode (411) and the other end electrically connected to the ground terminal of the control unit (30); and
a second resistor (415) having an end electrically connected to the ground terminal of the control unit (30) and the other end electrically connected to a node between the first capacitor (412) and the anode of the diode (411).

4. The solid-state circuit breaker of any one of claims 1 to 3, **characterized in that** the control unit (30) is electrically connected to the driving circuit (20) to send a control signal to the driving circuit (20), and the driving circuit (20) controls the switching unit (10) to be turned on in response to receiving the control signal.

5. The solid-state circuit breaker of any one of claims 1 to 3, **characterized in that** the first signal comprises at least one of a pulse width modulation signal and a fixed frequency pulse signal.

6. The solid-state circuit breaker of claim 2 or 3, **characterized by** further comprising:
an undervoltage protection circuit (50) electrically connected to the logic conversion circuit (42),wherein the undervoltage protection circuit (50) is adapted to generate a second signal in a case that an undervoltage occurs in a circuit, so that the logic conversion circuit (42) controls the driving circuit (20) to be in the second state at least in response to receiving the second signal.

7. The solid-state circuit breaker of claim 2 or 3, **characterized by** further comprising:
a short-circuit protection circuit (60) electrically connected to the logic conversion circuit (42), wherein the short-circuit protection circuit (60) is adapted to generate a third signal in a case that a short-circuit condition occurs in a main loop, so that the logic conversion circuit (42) controls the driving circuit (20) to be in the second state at least in response to receiving the third signal.

8. The solid-state circuit breaker of claim 2 or 3, **characterized by** further comprising:
an over-temperature protection circuit (70) electrically connected to the logic conversion circuit (42), wherein the over-temperature protection circuit (70) is adapted to generate a fourth signal in a case that an over-temperature condition occurs in a main loop, so that the logic conversion circuit (42) controls the driving circuit (20) to be in the second state at least in response to receiving the fourth signal.

9. The solid-state circuit breaker of any one of claims 1 to 3, **characterized in that** the driving circuit (20) comprises an application-specific integrated circuit or a circuit formed by connecting a plurality of discrete components.

10. The solid-state circuit breaker of any one of claims 1 to 3, **characterized in that** the switching unit (10) comprises at least one of a metal oxide semiconductor field effect transistor or an insulated gate bipolar transistor.
